Europäisches Patentamt

European Patent Office

Office européen des brevets

(19)

(11) Publication number : **0 391 603 B1**

## (12) EUROPEAN PATENT SPECIFICATION

(45) Date of publication of patent specification :
21.06.95 Bulletin 95/25

(51) Int. Cl.⁶ : **G06K 19/07**, G11C 5/14,
G11C 5/00, G11C 8/00

(21) Application number : 90303344.7

(22) Date of filing : 29.03.90

(54) Information card.

(30) Priority : 05.04.89 JP 85983/89
21.11.89 JP 304245/89

(43) Date of publication of application :
10.10.90 Bulletin 90/41

(45) Publication of the grant of the patent :
21.06.95 Bulletin 95/25

(84) Designated Contracting States :
DE FR GB

(56) References cited :
EP-A- 0 111 153
EP-A- 0 187 953
EP-A- 0 241 693
US-A- 4 399 524
PATENT ABSTRACTS OF JAPAN vol. 8, no.
204 (P-301)(1641)24 May 1984 & JP-A-59 090
278 ( TOSHIBA K.K. ) 12 November 1982
EP-A-0 241 693

(73) Proprietor : MITSUBISHI DENKI KABUSHIKI
KAISHA
2-3, Marunouchi 2-chome
Chiyoda-ku
Tokyo (JP)

(72) Inventor : Shinohara, Takayuki, c/o Mitsubishi
Denki
Kitaitami Seisakusho,
No. 1, Mizuhara 4-chome
Itami-shi, Hyogo-ken (JP)

(74) Representative : Beresford, Keith Denis Lewis
et al
BERESFORD & Co.
2-5 Warwick Court
High Holborn
London WC1R 5DJ (GB)

## Description

## FIELD OF THE INVENTION

The present invention relates to an information card comprising a plurality of volatile memory circuits and capable of backing up data stored in the volatile memory circuits by an internal battery and more particularly, to an information card comprising means for preventing stored data from being destroyed by an external noise when an external power supply is OFF or when a memory is backed up by the internal battery.

## BACKGROUND OF THE INVENTION

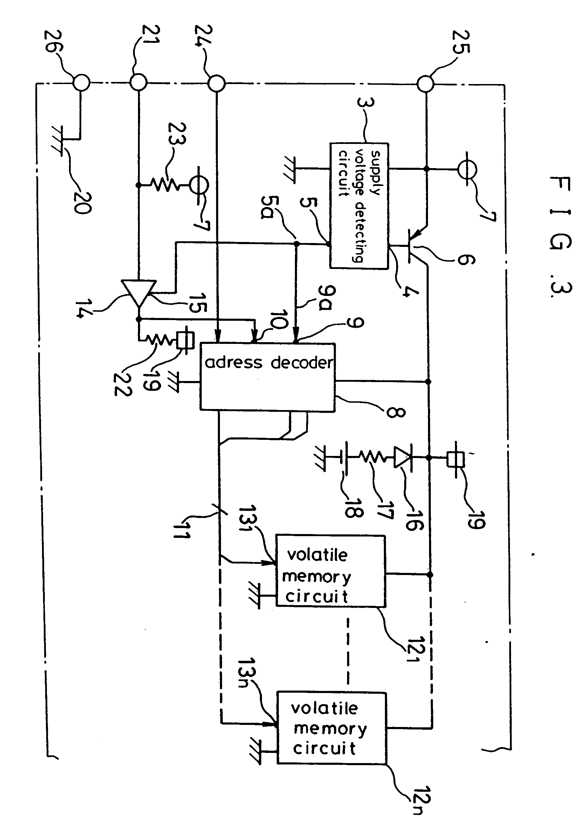

Figure 3 is a block diagram showing a memory card as a conventional information card comprising a plurality of integrated circuits of volatile memory circuits. In figure 3, reference numeral 3 designates a supply voltage detecting circuit for observing a voltage of an external 5V power supply 7 for the memory card supplied from an external power supply through a power supply input terminal 25. The supply voltage detecting circuit 3 has its first output terminal 4 connected to a base of a PNP transistor 6. Its output turns the transistor 6 ON or OFF and performs switching operation between the external 5V power supply 7 and the internal power supply 19. In addition, a second output terminal 5 of the supply voltage detecting circuit 3 is connected to a "H" active enable input terminal 9 of an address decoder 8 and a "H" active output control input terminal 15 of a buffer 14 for a card enable input. An output 11 of the address decoder 8 is connected to chip select input terminals $13_1$ to $13_n$ of the plurality of volatile memory circuits $12_1$ to $12_n$, which form a body of the memory card. The volatile memory circuits $12_1$ to $12_n$ are commonly connected to a power supply line on the collector side of the transistor 6 which performs switching operation between the external 5V power supply 7 and the internal power supply 19. The power supply line is connected to a primary battery 18 through a diode 16 for preventing a reverse current and a current controlling resistor 17. Data stored in the volatile memory circuits $12_1$ to $12_n$ is backed up by the primary battery 18. In addition, reference numeral 22 designates a resistor for pulling up an input of the buffer 14 for the card enable input to a voltage of the external power supply 7, reference numeral 21 designates a card enable terminal, reference numeral 24 designates a higher rank address input terminal for supplying a higher rank address input of the memory card to the address decoder 8 and reference numeral 26 designates a 0V power supply input terminal. In addition, the supply voltage detecting circuit 3, the address decoder 8, the volatile memory circuits $12_1$ to $12_n$, the buffer 14 and the like can be implemented by using an IC (integrated circuit).

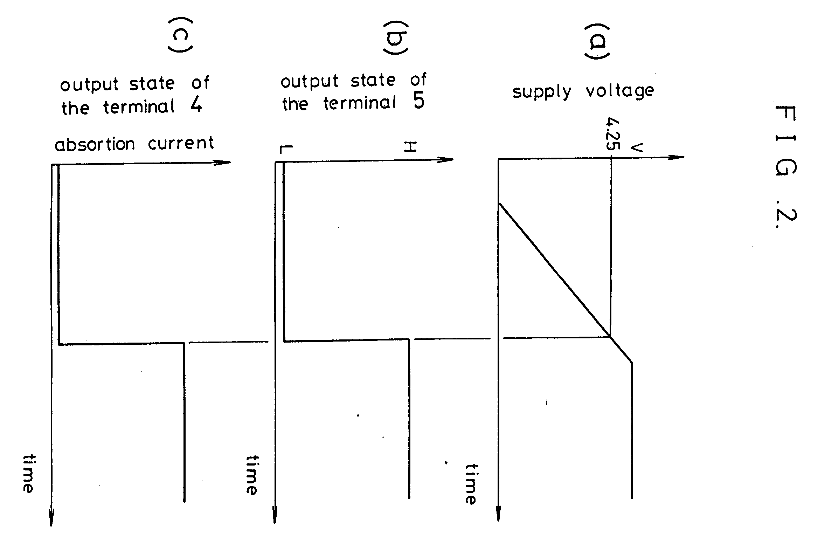

Next, operation of this conventional example will be described in reference to an operating signal waveform of the supply voltage detecting circuit 3 shown in figure 2. In figure 3, when a memory is backed up, that is, when a voltage of the external 5V power supply 7 is less than, for example 4. 25V (figure 2(a)), it is detected by the supply voltage detecting circuit 3 and an output of the first output terminal 4, that is, an absorption current output is turned OFF (figure 2(c)) and a voltage output of the second output terminal 5 attains "L" level (figure 2(b)). Therefore, the transistor 6 is turned OFF and a signal of the "H" active enable input terminal 9 of the address decoder and a signal of the "H" active output control input terminal 15 of the buffer 14 for the card enable input attain "L" level. Therefore, all of the outputs 11 of the address decoder 8 attain "H" level and all of the volatile memory circuits $12_1$ to $12_n$ in the memory card become a standby state by a supply voltage supplied from the internal power supply 19, that is, the primary battery 18 and then data in the memory circuits $12_1$ to $12_n$ is stored.

A description is given of a case where in the above memory backup state, there is generated electrostatic discharge through the memory card body (more specifically, electrostatic discharge generated when the memory card held by a person charged with electricity is inserted into a system equipment). If a discharge current or an induced current I [A] due to the discharge current has flown into the "H" active enable input line 9a (which is the same as the "H" active output control input line of the card enable input buffer 14) of the address decoder 8 for $t_0$ [sec] by the electrostatic discharge, a voltage expressed by the following equation is generated on the "H" active enable input line 9a of the address decoder 8, that is;

$$V = \frac{1}{C_0} \int_o^{t_0} I\,dt \quad [V] \quad \ldots (1)$$

where $C_0$ is line capacitance [F] between the enable input line 9a and the 0V power supply 20. When a voltage V exceeds a threshold voltage of the "H" active enable input line 9a of the address decoder 8, its output 11 is output and one of the volatile memory circuits $12_1$ to $12_n$ becomes an active state, which could cause the stored data in the memory circuits $12_1$ to $12_n$ to be destroyed (erroneously written).

Since the conventional memory card is structured as described above, line capacitance between the enable input line of the address decoder and the 0V power supply is considerably small (several pF), so that the data stored in the memory card is sometimes destroyed by a comparatively small discharge current I. For example, when $V = 2V$, $C_0 = 5pF$, $t_0 = 100nsec$, and

$$\int_0^{t_0} I\,dt = I \times t_0,$$

a discharge current I is as follows;

$$I = \frac{V \times C_0}{t_0}$$
$$= \frac{2 \times 5 \times 10^{-12}}{100 \times 10^{-9}}$$
$$= 1 \times 10^{-4}\,[A] = 0.1\,[mA]$$

However, the address decoder erroneously operates at this current, causing the data stored in the memory card to be destroyed.

The present invention was made in view of the above problems and it is a concern of the present invention to provide an information card in which stored data is not destroyed at the time of backup of the memory card.

European Patent Specification No. EP-A-0,187,953 discloses a circuit for protecting data in memory housed in a plug-in cartridge.

In accordance with the present invention there is provided an information card as set out in claim 1.

In order that the present invention may be more readily understood an embodiment thereof will now be described by way of example and with reference to the accompanying drawings, in which:

Figure 1 is a block diagram showing an information card which provides a background to the present invention;

Figure 2 is a signal waveform chart used when operation of a supply voltage detecting circuit is described in the Figure 1 embodiment and in a conventional example;

Figure 3 is a block diagram showing a conventional memory card as an information card; and

Figure 4 is a block diagram showing an information card in accordance with the present invention.

Embodiments of information cards will be described in detail with reference to the drawings.

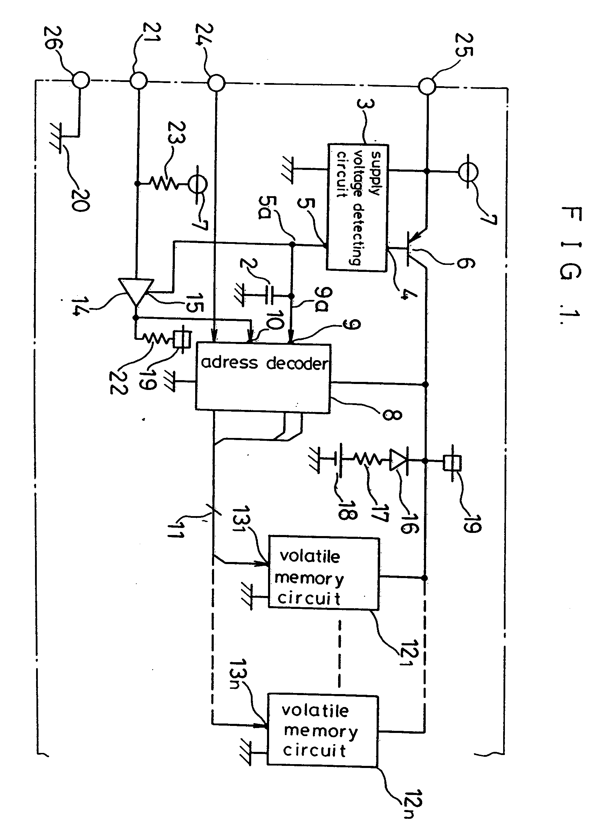

Figure 1 is a block diagram showing a memory card used as an information card.

According to the embodiment of Figure 1, a capacitor 2 for reducing high frequency impedance of a "H" active enable input line 9a is provided between the "H" active enable input line 9a of an address decoder 8 selecting a plurality of volatile memory circuits $12_1$ to $12_n$ and a 0V power supply (low voltage common power supply) 20. A structure other than that is the same as that shown in figure 3.

In figure 1, reference numeral 3 designates a supply voltage detecting circuit which observes, for example a voltage of a 5V power supply 7 for a memory card supplied from an external power supply through a power supply input terminal 25. When the voltage of the 5V power supply 7 supplied from the external power supply becomes a set voltage (4. 25V) or more, the supply voltage detecting circuit 3 absorbs a current on a first output terminal 4 and turn ON a PNP transistor 6 which switches the external 5V power supply 7 to an internal power supply 19. Then, when the voltage of the external 5V power supply 7 is less than 4. 25V, a current absorbing output is turned OFF and the transistor 6 is turned OFF. Then, a card internal circuit comprising the plurality of volatile memory circuits $12_1$ to $12n$ is operated by the internal power supply 19. At this time, a second output terminal 5 of the supply voltage detecting circuit 3 generates an output of "H" level when the voltage of the external 5V power supply 7 is 4. 25V or more and it generates an output (memory protect output) of "L" level when it is less than 4. 25V. The output is connected to the "H" active enable input terminal 9 of the address decoder 8 through a "H" active output control input terminal 15 of the buffer 14 for the card enable input. In addition, the capacitor 2 is connected between the "H" active enable input line 9a from a memory protect output line 5a to the "H" active enable input terminal 9 of the address decoder 8 and the 0V power supply 20 so as to reduce the high frequency impedance of the "H" active enable input line 9a. An output 11 of the address decoder 8 is connected to "L" active chip select input terminals $13_1$ to $13_n$ of the volatile memory circuits $12_1$ to $12_n$. Reference numeral 16 designates a diode for preventing a reverse current, which prevents a charging current from flowing into a primary battery 18, reference numeral 17 designates a current controlling resistor for controlling a charging current flowing into the primary battery 18 when the diode 16 short-circuits, reference numeral 22 designates a resistor for pulling up an output of the buffer 14 for the card enable input, to the internal power supply 19, reference numeral 23 designates a resistor for pulling up an input of the buffer 14 for the card enable input, to the external power supply 7 and reference numeral 24 designates a higher rank address input terminal for supplying higher rank address of the memory card to the address decoder 8, reference numeral 21 designates a card enable input terminal of the memory card and reference numeral 26 designates a 0V power supply input terminal of the memory card.

Next, operation of the above structure will be described in reference to an operating waveform of the supply voltage detecting circuit 3 shown in figure 2.

In figure 1, when memory is backed up, that is, when the external 5V supply voltage is less than 4. 25V (figure 2(a)), an output of the first output terminal 4 of the supply voltage detecting circuit 3, that is, an adsorption current is turned OFF (figure 2(c)) and the second output terminal 5 attains "L" level (figure 2(b)). Therefore, the transistor 6 is turned OFF and then a supply voltage is applied to the volatile memory circuits $12_1$ to $12_n$ from the internal power supply 19, that is, the primary battery 18. At the same time, the "H" active enable input 9 of the address decoder 8 attains "L" level and then all chip select inputs of the volatile memory circuits $12_1$ to $12_n$ attain "H" level, whereby all the volatile memory circuits $12_1$ to $12_n$ become a standby state.

In the above memory backup state, a voltage V generated on the "H" active enable input line 9 of the address decoder 8 by an electrostatic discharge through the memory card body is expressed by the following equation, that is,

$$V = \frac{1}{C} \int_{o}^{to} I\,dt \quad [V] \quad \ldots (2)$$

where C is capacitance [F] of the capacitor 2 inserted between the enable input of the address decoder 8 and the 0V power supply 20, I is a current [A] flowing into the enable input line of the address decoder 8 by the electrostatic discharge, $t_0$ is time [sec] while the current I flows. However, if an amount of electric charge

$$\int_{o}^{to} I\,dt$$

generated at the enable input of the address decoder 8 by the electrostatic discharge in the equation (1) is equal to that in the equation (2), a voltage generated on the enable input of the address decoder 8 by the electrostatic discharge is reduced $C_0/C$-fold because the capacitor 2 is inserted. For example, when $C_0$ is several pF and C is several 100pF, a voltage generated at the enable input of the address decoder 8 is 1/100. As a result, erroneous operation of the address decoder 8 caused by an external noise such as electrostatic discharge at the time of backup of the volatile memory circuits $12_1$ to $12_n$ is prevented and also destruction of internal stored data is prevented.

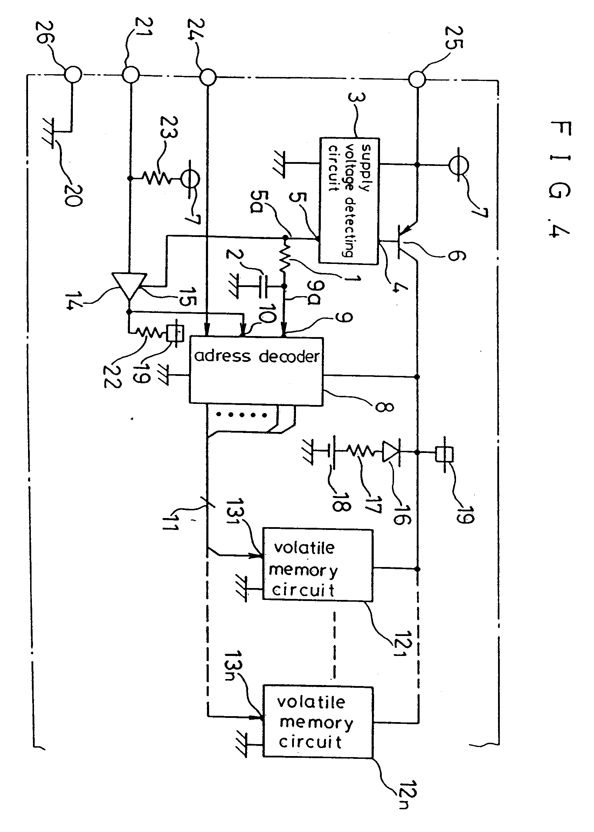

Next, a description will be given of operation when the external power supply is OFF in an embodiment of the present invention in reference to figure 4. This embodiment is different from the first embodiment in that a resistor 1 is provided between the "H" active enable input line 9a and the capacitor 2 because discharge of the capacitor 2 sometimes causes delay of a memory protect output in the first embodiment. More specifically, an electric charge Q[C] in the capacitor 2 is discharged through an output resistor $R_0[\Omega]$ (not shown) of the second output terminal 5 of the supply voltage detecting circuit 3. When time t = 0, discharge is started. A power supply $V_p[v]$ of the memory protect output line 5a after t [sec] is expressed as follows;

$$V_p = \frac{Q}{C} \exp\left[ -\frac{t}{CR_0} \right] [v] \quad \ldots (3)$$

The memory protect output is connected to the "H" active enable terminal 9 of the address decoder 8 and the "H" active output control terminal 15 of the buffer 14 for the card enable input. Since the card enable input terminal 21 is pulled up to the external 5V power supply 7 by the resistor 23, the card enable input terminal 21 falls in accordance with almost the same signal waveform as when the external 5V power supply 7 falls. Therefore, the voltage of the external 5V power supply 7 falls steeper as compared with the power supply $V_p$ shown in the equation (2). Then, when the card enable input, that is, the input level of the external 5V power supply 7 attains "L" level while the output control terminal 15 of the buffer 14 for the card enable input is at "H" level, the address decoder 8 operates and one of the volatile memory circuits $12_1$ to $12_n$ becomes an active

state, causing a possibility that data in the memory circuits is destroyed (erroneously written).

This problem can be solved by providing the resistor 1 as described above in the following manner. That is, when the external 5V power supply 7 is supplied, a signal at "H" level is output on the second output terminal 5 of the supply voltage detecting circuit 3 and the capacitor 2 connected between the "H" active enable terminal 9 of the address decoder 8 and the 0V power supply 20 through the output and the resistor 1 is charged at the same level as that of the second output terminal 5 of the supply voltage detecting circuit 3. When the external 5V power supply 7 is turned OFF from this state and the external 5V power supply 7 is less than 4. 25V, the second output terminal 5 of the supply voltage detecting circuit 3 outputs a signal at "L", level and then memory protection is applied. At this moment, as the capacitor 2 charged at "H" level starts discharge through the resistor 1, the memory protection is not immediately applied to the "H" active enable input terminal 9 of the address decoder 8. More specifically, when the external 5V power supply 7 is ON, an electric charge in the capacitor 2 is Q [C] and a voltage $V_{CE}$ of the "H" active input terminal 9 of the address decoder 8 t [sec] after the external 5V power supply 7 fell below 4. 25 is as follows;

$$V_{CE} = \frac{Q}{C} \exp \left[ - \frac{t}{CR} \right] \quad [v] \ \ldots \ (4)$$

where, C is electrostatic capacitance [F] of the capacitor 2 and R is a resistance value [$\Omega$] of the resistor 1. When the value R [$\Omega$] of the resistor 1 is set so as to be considerably larger than an output resistance $R_0$ of the second output terminal 5 of the supply voltage detecting circuit 3, a voltage of the second output terminal 5, that is, a voltage of the "H" active output control input terminal 15 of the buffer 14 for the card enable input attains "L" level without any influence from the capacitor 2 and an output of the buffer 14 becomes high impedance. Therefore, the "L" active enable terminal 10 of the address decoder 8 is pulled up to the internal power supply 19 by the resistor 22, whereby it attains "H" level and then delay of the memory protect can be prevented and it is possible to prevent destruction of the internal stored data due to the delay of the memory protect output when the external power supply is OFF. An amount of the electrostatic discharge when the memory card in accordance with this embodiment of the present invention is backed up is the same as that of the memory card without the resistor 1.

According to the above embodiments of the present invention, it is possible to prevent delay of the memory protect output due to the capacitor 2 between the "H" active enable input line 9a and the 0V power supply 20 when the external power supply is OFF because the resistor 1 is inserted between the memory protect signal line 5a output from the second output terminal 5 of the supply voltage detecting circuit 3 and the "H" active enable input line 9a of the address decoder 8. More specifically, since a change of a potential from the capacitor 2 is not immediately transferred to the memory protect signal line 5a because of the resistor 1, the memory protect output is not likely to be influenced thereby. As a result, delay of the memory protect output is prevented and also destruction of data inside the memory is prevented.

Although the voltage of the external power supply is 5V in the above embodiments of the present invention, the voltage of the external power supply may be set in accordance with an operation voltage of the circuit elements. In addition, the internal battery is not limited to the primary battery and secondary battery may be used for that.

According to the present invention, since a capacitor for reducing high frequency impedance of the "H" active enable input line is provided between the "H" active enable input line of the address decoder and the low voltage common power supply, high frequency impedance of the "H" active enable input line can be reduced and resistance against an external noise can be improved, which is mainly caused by electrostatic discharge in relation to destruction of inside data at the time of backup. In addition, according to the present invention, since a resistor for discharging electricity in the capacitor when the external power supply is OFF is provided between the capacitor for reducing high frequency impedance of the "H" active enable input line and the "H" active enable input line, an electric charge in the capacitor is slowly discharged and destruction of the inside data when the external power supply is OFF or at the time of memory backup by the internal battery can be prevented, so that reliability can be improved.

**Claims**

1. An information card comprising a plurality of volatile memory circuits ($12...12_1...12_n$), an address decoder (8) by means of which the memory circuits can be accessed, and means (18) for providing back-up power for the memory circuit when the level of an external power supply (7) falls below a predetermined level as detected by a voltage detecting circuit (3) providing memory protection by supplying on an output terminal (5) a signal to an enable input terminal (9) of the address decoder and to a control input (15) of a buffer (14) for coupling together a card enable terminal (21) and another enable input (10) of the address decoder, and characterised in that there is additionally provided a capacitor (2) connected between the enable input terminal (9) and an OV power supply so as to reduce high-frequency impedance on the line to the enable input terminal (9), and a resistor (1) connected between the line from the output terminal (5) to the control input (15) and the capacitor (2) for preventing any charge stored in the capacitor (2) from affecting rapid switching of the control input (15).

## Patentansprüche

1. Informationskarte mit einer Vielzahl flüchtiger Speicherschaltungen ($12...\ 12_1....\ 12_n$), einem den Zugriff auf die Speicherschaltungen ermöglichenden Adressendekoder (8) und mit Mitteln (18), die eine Reservestromversorgung für die Speicherschaltung bereitstellen, wenn der von einer Spannungsfeststellschaltung (3) festgestellte Pegel einer externen Stromversorgung (7) unter einen vorbestimmten Pegel fällt, wobei die Spannungsfeststellschaltung (3) einen Speicherschutz bietet, indem sie ein Signal auf einem Ausganganschluß (5) sowohl an einen Aktivierungseingangsanschluß (9) des Adressendekoders liefert als auch an einen Steuereingang (15) eines Puffers (14) zur Zusammenschaltung eines Kartenaktivierungsanschlusses (21) mit einem anderen Aktivierungseingang (10) des Adressendekoders, **dadurch gekennzeichnet,** daß zusätzlich ein zwischen den Aktivierungseingangsanschluß (9) und eine 0 V- Stromversorgung geschalteter Kondensator (2) zur Herabzusetzung der Hochfrequenzimpedanz auf der Leitung zum Aktivierungseingangsanschluß (9) vorgesehen ist und daß ein zwischen die Leitung vom Ausgangsanschluß (5) zum Steuereingang (15) und den Kondensator (2) geschalteter Widerstand (1) vorgesehen ist, der eine beliebige in dem Kondensator (2) gespeicherte Ladung daran hindert, den Steuereingang (15) schnell umzuschalten.

## Revendications

1. Une carte de support d'information comprenant un ensemble de circuits de mémoire volatile ($12 ...\ 12_1 ...\ 12_n$), un décodeur d'adresse (8) au moyen duquel on peut accéder aux circuits de mémoire, et des moyens (18) pour fournir de l'énergie de secours pour le circuit de mémoire lorsque le niveau d'une alimentation externe (7) tombe au-dessous d'un niveau prédéterminé, d'après ce que détecte un circuit de détection de tension (3) assurant une protection de mémoire par l'application d'un signal, à partir d'une borne de sortie (5), à une borne d'entrée de validation (9) du décodeur d'adresse et à une entrée de commande (15) d'un amplificateur-séparateur (14) qui est destiné à connecter ensemble une borne de validation de carte (21) et une autre entrée de validation (10) du décodeur d'adresse, et caractérisée en ce qu'elle comporte en outre un condensateur (2) connecté entre la borne d'entrée de validation (9) et un point d'alimentation de 0 V, de façon à réduire l'impédance en haute fréquence sur la ligne dirigée vers la borne d'entrée de validation (9), et une résistance (1) connectée entre la ligne allant de la borne de sortie (5) à l'entrée de commande (15), et au condensateur (2), pour éviter qu'une charge quelconque qui est emmagasinée dans le condensateur (2) n'affecte la rapidité de commutation de l'entrée de commande (15).

F I G .1.

supply voltage detecting circuit

adress decoder

volatile memory circuit

volatile memory circuit

# F I G .2.

EP 0 391 603 B1

F I G. 3.

FIG.4